# FASCICULE DE BREVET EUROPEEN

(11) **EP 1 771 593 B1**
(45) Date de publication et mention de la délivrance du brevet: **17.10.2012**
(21) Numéro de dépôt: 05749098.9
(22) Date de dépôt: 17.06.2005
(51) Int. Cl.: C23C 16/04, C23C 16/511

(54) **MACHINE DE TRAITEMENT DE BOUTEILLES EQUIPEES D'UNE CARTOUCHE DE RACCORDEMENT INTERCHANGEABLE**
MASCHINE ZUR BEHANDLUNG VON FLASCHEN MIT AUSTAUSCHBARER VERBINDUNGSKARTUSCHE
MACHINE FOR THE TREATMENT OF BOTTLES THAT ARE EQUIPPED WITH AN INTERCHANGEABLE CONNECTION CARTRIDGE

(30) Priorité: 24.06.2004 FR 0451328
(43) Date de publication de la demande: 11.04.2007
(73) Titulaire: Sidel Participations, 76930 Octeville sur Mer (FR)
(72) Inventeur: DUCLOS, Yves-Alban, SIDEL, F-76930 Octeville sur Mer (FR)
(74) Mandataire: Kohn, Philippe
(86) Numéro de dépôt international: PCT/EP2005/052811
(87) Numéro de publication internationale: WO 2006/000539

(56) Documents cités:
- WO-A-01/31680
- WO-A-02/10473
- WO-A-95/22413
- FR-A- 2 783 667
- US-A- 5 521 351
- PATENT ABSTRACTS OF JAPAN vol. 007, no. 285 (C-201), 20 décembre 1983 (1983-12-20) & JP 58 164788 A (FUJITSU KK), 29 septembre 1983 (1983-09-29)

## Description

La présente invention concerne une machine de traitement de récipients, tels que des bouteilles, flacons ou analoques.

La présente invention concerne plus particulièrement une machine de traitement de récipients par dépôt d'un revêtement interne formant barrière au moyen d'un plasma micro-ondes, notamment en vue de permettre le conditionnement de liquides oxydo-sensibles dans les récipients, comportant au moins un poste de traitement pour un récipient muni d'un col, du type dans laquelle chaque poste de traitement comporte une enceinte de traitement qui est prévue pour contenir récipient et un couvercle qui est monté coulissant axialement par rapport à l'enceinte et qui est pourvu d'une tuyère équipée de moyens de préhension pour saisir extérieurement le récipient par son col de manière à permettre l'insertion axiale du récipient à l'intérieur de l'enceinte par une ouverture correspondante, et équipée de moyens de raccordement étanche entre l'intérieur du récipient et une chambre de pompage à vide qui est aménagée dans le couvercle, du type dans laquelle les moyens de raccordement étanche comportent une cartouche qui est montée dans le couvercle, qui a une forme globalement tubulaire coaxiale au col du récipient, et qui est en contact étanche avec le buvant du récipient saisi par les moyens de préhension.

Dans ce type de machine, le récipient est généralement agencé à l'endroit, c'est-à-dire avec le col dirigé vers le haut, la tuyère coulissant axialement du haut vers le bas pour saisir le récipient et l'amener dans l'enceinte.

Généralement, la cartouche de raccordement est constituée par une chemise cylindrique qui est munie d'un joint d'étanchéité à son extrémité inférieure et qui est insérée axialement à l'intérieur de la tuyère, de manière à déboucher directement, par son extrémité axiale inférieure, dans la chambre de pompage à vide.

Pendant le traitement du récipient, un champ de micro-ondes est émis à l'intérieur de l'enceinte de traitement et ce champ se développe vers la chambre de pompage à travers la chemise.

Les micro-ondes qui se propagent à l'intérieur de la chemise et à l'intérieur de la chambre de pompage y provoquent des dépôts de particules de matériau barrière (carbone, silice, autre - dépendant du fluide réactionnel utilisé), ce qui pollue les parois internes de la chemise et de la chambre de pompage, voire même les parois internes du circuit de pompage.

Pour cette raison, il est nécessaire de procéder fréquemment à un arrêt de la machine et à un nettoyage de la cartouche ainsi que de la chambre de pompage.

La présente invention vise notamment à remédier à cet inconvénient de manière simple, efficace, et économique.

Le document WO0131680 décrit un système commun de traitement interne de récipients, et le document JP58164788 décrit un appareil CVD possédant un écran maillé prévenant la transmission de micro-ondes entre la chambre de traitement et la chambre d'introduction et d'excitation des gas.

L'invention propose une machine de traitement du type décrit précédemment, caractérisée en ce que la cartouche comporte un tronçon axial, dit tronçon de raccordement, qui s'étend à l'intérieur de la chambre de pompage et qui est pourvu d'orifices radiaux, et en ce que la chambre de pompage communique avec l'intérieur de la cartouche à travers les orifices radiaux, les dimensions nominales de chaque orifice étant aptes à empêcher la diffusion vers la chambre de pompage des micro-ondes émises à l'intérieur du récipient pendant le traitement.

Selon d'autres caractéristiques de l'invention :
- la paroi axiale du tronçon de raccordement comporte au moins une fenêtre et chaque fenêtre est obturée par un élément de paroi axiale rapporté dans lequel sont agencés les orifices ;
- l'élément de paroi axiale est constitué par un manchon perforé rapporté à l'intérieur de la cartouche ;
- la cartouche comporte un tronçon axial formant une entretoise tubulaire qui est intercalée axialement entre le buvant du récipient et le tronçon de raccordement, et qui est fixée sur une extrémité axiale associée du tronçon de raccordement ;
- la cartouche comporte un joint annulaire d'étanchéité qui réalise le raccordement étanche entre la cartouche et le buvant du récipient et qui est fixé sur l'extrémité axiale de l'entretoise opposée au tronçon de raccordement ;
- les moyens de préhension comportent un manchon tubulaire de support, coaxial au col de la récipient, qui est monté dans un logement du couvercle, et la paroi axiale concave du manchon de support comporte un épaulement qui est prévu pour venir en appui axial contre le joint annulaire d'étanchéité de la cartouche ;
- la cartouche comporte, du côté opposé au récipient, un tronçon d'extrémité axiale dit tronçon de liaison qui possède une paroi axiale pleine et qui est en contact étanche, par son extrémité axiale libre, avec le corps d'un dispositif prévu pour injecter du fluide réactionnel à l'intérieur du récipient pendant le traitement ;
- le tronçon de liaison a globalement une forme cylindrique et la cartouche comporte une chemise cylindrique qui est agencée contre la paroi axiale concave du tronçon de liaison et qui s'étend globalement sur toute la longueur axiale du tronçon de liaison ;
- le tronçon de liaison et le tronçon de raccordement sont réalisés d'une seule pièce et ils constituent le corps principal de la cartouche ;
- la cartouche est montée dans un logement complémentaire du couvercle, en ce que le couvercle comporte un organe de verrouillage qui est muni d'une surface radiale d'appui mobile entre une position verrouillée et une position de libération, et la cartouche comporte une collerette radiale externe qui est prévue pour être serrée axialement entre une portion associée du couvercle et la surface d'appui de l'organe de verrouillage en position verrouillée de manière à retenir la cartouche en position montée dans le logement du couvercle.

D'autres caractéristiques et avantages de l'invention apparaîtront à la lecture de la description détaillée qui suit pour la compréhension de laquelle on se reportera aux dessins annexés dans lesquels :
- la figure 1 est une vue en coupe axiale partielle éclatée qui représente schématiquement un poste de traitement de la machine selon l'invention lorsque le couvercle occupe une position axiale haute de transfert par rapport au châssis ;
- la figure 2 est une vue similaire à la précédente qui représente schématiquement le couvercle dans une position axiale intermédiaire lorsque un récipient est saisie par des moyens de préhension et partiellement introduite dans une enceinte de traitement ;
- la figure 3 est une vue en coupe axiale qui représente partiellement le couvercle lorsque les moyens de préhension sont prêts à saisir le col d'un récipient ;
- la figure 4 est une vue en coupe axiale qui représente partiellement le couvercle équipé d'une cartouche et d'un injecteur de fluide réactionnel lorsque le couvercle occupe sa position basse de traitement et qu'il vient fermer l'enceinte de traitement, un récipient étant saisie par les moyens de préhension ;
- la figure 5 est une vue en perspective qui représente partiellement le capot inférieur du couvercle en position basculée vers le bas, le sous-ensemble formant les moyens de préhension étant partiellement monté dans son logement ;
- la figure 6 est une vue en perspective qui représente partiellement le capot supérieur du couvercle avant le montage de la cartouche, l'organe de verrouillage de la cartouche occupant sa position de libération.

Dans la description qui va suivre, des éléments identiques, similaires ou analogues seront désignés par les mêmes chiffres de référence.

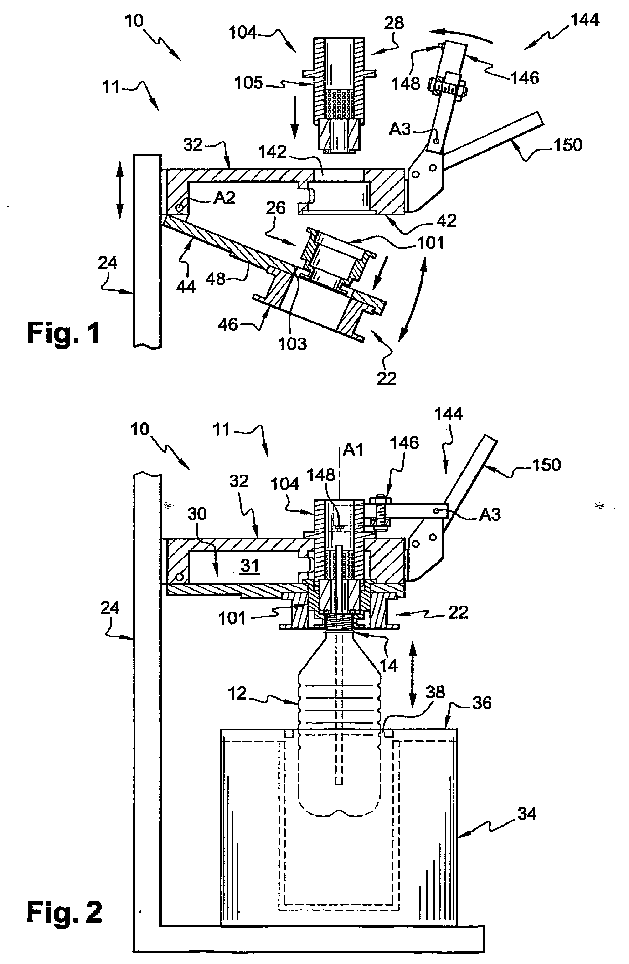

Sur la figure 1, on a représenté partiellement une machine 10 de traitement de récipients 12 qui est réalisée conformément aux enseignements de l'invention.

La machine 10 vise à réaliser le dépôt d'un revêtement interne formant barrière au moyen d'un plasma micro-ondes, notamment en vue de permettre le conditionnement d'un liquide oxydo-sensible dans les récipients 12.

De manière classique, la machine 10 comporte plusieurs postes de traitement 11 qui peuvent être répartis circonférentiellement de manière régulière sur un support rotatif (non représenté), chaque poste de traitement 11 étant prévu pour traiter un récipient 12 à la fois.

Sur les figures, on a représenté partiellement un seul poste de traitement 11.

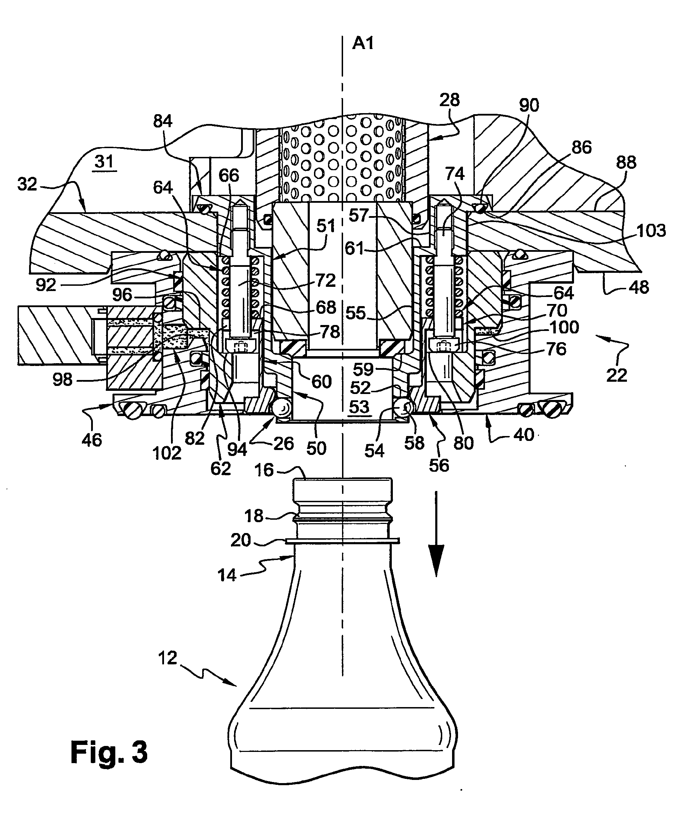

Comme on peut le voir en particulier sur la figure 3, chaque récipient 12 est muni, à son extrémité axiale supérieure, d'un col 14 qui délimite une ouverture supérieure dont le rebord constitue le buvant 16 du récipient 12.

Le col 14 est muni d'une première collerette radiale externe 18 et d'une seconde collerette radiale externe 20 agencée sous la première collerette radiale externe 18.

De façon avantageuse, lorsque le récipient 12 est une bouteille, la première collerette radiale externe 18 peut être constituée par la bague d'inviolabilité qui est en général présente sur le col de la bouteille et est destinée à coopérer avec un anneau d'inviolabilité présent sur le bouchon, et qui se déchire lorsque le récipient est ouvert.

Chaque poste de traitement 11 comporte une tuyère 22 de forme globalement cylindrique qui est montée à coulissement suivant un axe sensiblement vertical A1 par rapport à un châssis 24, fixe, de la machine 10.

Dans la suite de la description, on utilisera à titre non limitatif une orientation axiale verticale suivant l'axe de coulissement A1, ce qui correspond à une orientation du haut vers le bas sur les figures.

Des éléments seront qualifiés de radiaux ou de transversaux en fonction de leur disposition par rapport à l'axe de coulissement A1.

La tuyère 22 comporte des moyens de préhension 26 pour saisir extérieurement le récipient 12 par son col 14 et des moyens de raccordement 28 pour raccorder de manière étanche l'intérieur du récipient 12 avec un circuit 30 de pompage à vide.

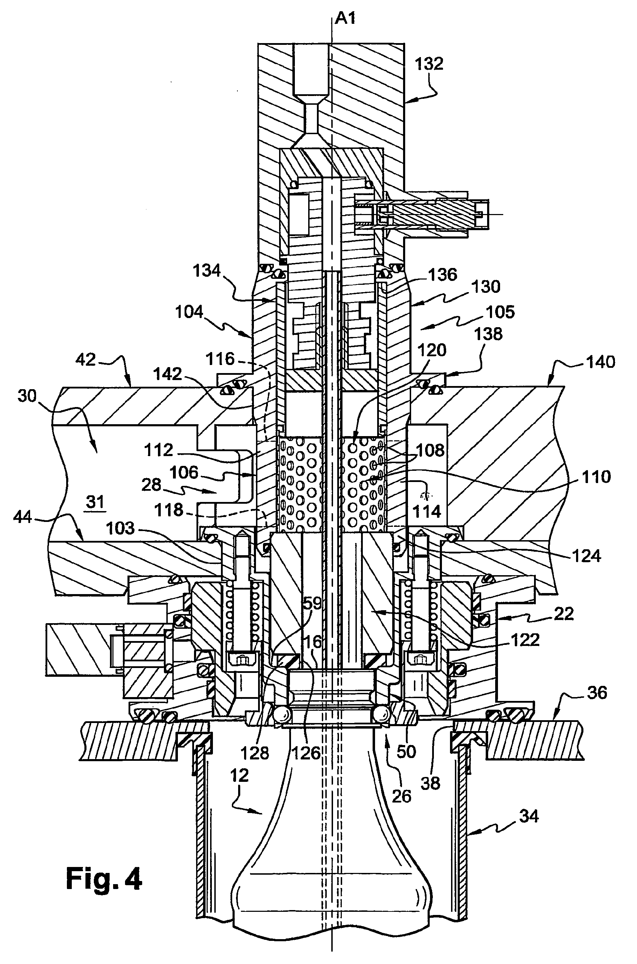

Selon le mode de réalisation représenté ici, la tuyère 22 est portée par un couvercle 32, et le couvercle 32 est monté coulissant axialement sur le châssis 24, entre une position haute de transfert, qui est représentée sur les figures 1 et 3, et une position basse de traitement, qui est représentée sur la figure 4.

Sur les figures, on a représenté une portion du circuit 30 de pompage qui est constituée par une chambre 31 de pompage aménagée à l'intérieur du couvercle 32 et qui est prévue pour être raccordée au récipient 12 par les moyens de raccordement 28.

Chaque poste de traitement 11 comporte aussi une enceinte 34 de traitement qui est fixée sur le châssis 24.

L'enceinte 34 de traitement comporte, dans une face transversale supérieure 36, une ouverture correspondante 38 qui est prévue pour permettre l'insertion axiale du récipient 12 à l'intérieur de l'enceinte 34.

La tuyère 22 comporte une portion annulaire de fermeture 40 qui est prévue pour venir en appui axial étanche contre une portion correspondante de la face transversale supérieure 36 de l'enceinte 34 de manière à fermer ladite ouverture correspondante 38.

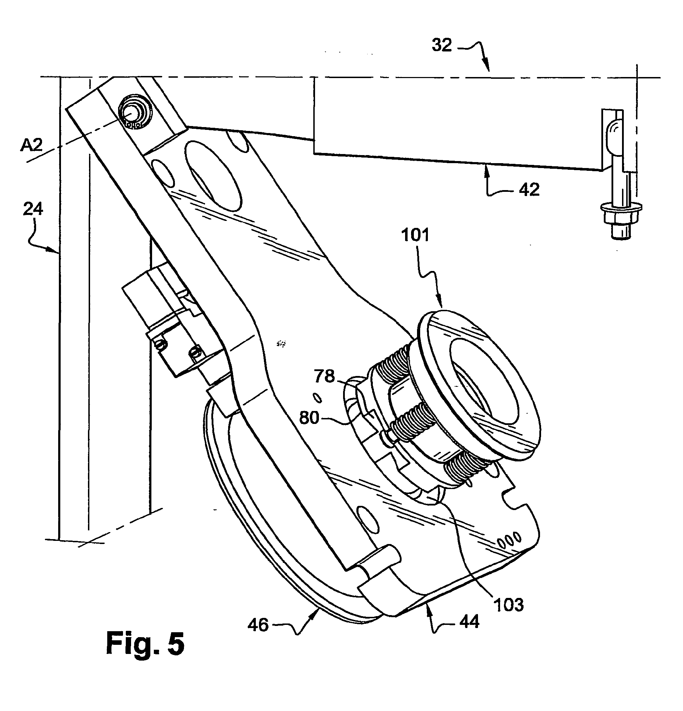

Le couvercle 32 comporte ici un capot supérieur 42 qui est monté à coulissement sur le châssis 24 et un capot inférieur 44 qui est monté à pivotement autour d'un axe transversal A2 par rapport au capot supérieur 42, entre une position ouverte de démontage, qui est représentée sur les figures 1 et 5, et une position fermée d'utilisation, qui est représentée notamment sur la figure 2.

L'utilité de la position de démontage sera expliquée par la suite.

La tuyère 22 comporte un corps principal 46 annulaire globalement cylindrique qui est fixé par son extrémité axiale supérieure sur la face transversale inférieure 48 du couvercle 32.

La face transversale d'extrémité inférieure du corps principal 46 constitue ici la portion annulaire de fermeture 40 de la tuyère 22.

Les moyens de préhension 26 comportent un manchon de support 50 qui est tubulaire et coaxial au col 14 du récipient 12, qui est fixe par rapport au corps principal 46 de la tuyère 22, et qui est muni d'une série de perçages radiaux 52 débouchants prévus pour recevoir chacun une bille 54 mobile radialement entre une position interne de préhension, qui est représentée sur la figure 4, et une position externe de libération, qui est représentée sur la figure 3.

Les perçages radiaux 52 sont ici de forme globalement cylindrique et ils constituent chacun un logement pour une bille 54.

De préférence, les perçages radiaux 52 sont agencés au voisinage de l'extrémité axiale inférieure du manchon de support 50 et ils sont répartis angulairement de manière régulière.

Lorsque les billes 54 occupent leur position radiale interne de préhension, elles sont prévues pour coopérer avec le col 14 du récipient 12 de manière à saisir le récipient 12.

Lorsque les billes 54 occupent leur position radiale externe de libération, elles sont prévues pour permettre le retrait du récipient 12 par rapport à la tuyère 22.

Selon le mode de réalisation représenté ici, la paroi axiale concave 51 du manchon de support 50 est étagée axialement de sorte qu'elle comporte un tronçon cylindrique d'extrémité axiale inférieure 53, un tronçon cylindrique intermédiaire 55, et un tronçon cylindrique d'extrémité axiale supérieure 57 qui sont adjacents et qui sont des diamètres internes respectifs croissants vers le haut.

Le tronçon cylindrique d'extrémité axiale inférieure 53 délimite avec le tronçon intermédiaire un épaulement 59 orienté vers le haut.

Le tronçon intermédiaire délimite avec le tronçon d'extrémité axiale supérieure 57 une surface radiale 61 orientée vers le haut.

Avantageusement, la dimension axiale du tronçon cylindrique d'extrémité axiale inférieure 53 est sensiblement égale à la dimension axiale du col 14 de le récipient 12 depuis la seconde collerette radiale externe 20 jusqu'au buvant 16 de manière que, lorsque le récipient 12 est saisie par les moyens de préhension 26, le buvant 16 soit agencé sensiblement à la même hauteur que l'épaulement 59, et que les billes 54 coopèrent par contact avec la première collerette radiale externe 18 en vue de solliciter le récipient 12 axialement vers le haut.

Les moyens de préhension 26 comportent ici un manchon de commande 56 qui est tubulaire, coaxial et externe au manchon de support 50.

Ce manchon de commande 56 est monté coulissant axialement par rapport au manchon de support 50 entre une position axiale inférieure verrouillée, qui est représentée sur la figure 4, et une position axiale supérieure déverrouillée, qui est représentée sur la figure 3.

Le manchon de commande 56 comporte une portée tronconique 58 qui est agencée sur sa paroi axiale concave 60 et qui est prévue pour coopérer avec les billes 54 de manière à les solliciter radialement vers leur position de préhension, lorsque le manchon de commande 56 coulisse depuis sa position déverrouillée vers sa position verrouillée.

A l'inverse, lorsque le manchon de commande 56 occupe sa position déverrouillée, les billes 54 sont libres de se déplacer radialement entre leur position de préhension et leur position de libération.

La tuyère 22 comporte des moyens d'entraînement 62 commandés susceptibles de provoquer le coulissement axial du manchon de commande 56 vers au moins une de ses deux positions axiales déterminées, c'est-à-dire la position axiale verrouillée et la position axiale déverrouillée.

Avantageusement, les moyens de préhension 26 comportent au moins un élément de rappel 64, élastique, qui sollicite axialement le manchon de commande 56 vers sa position verrouillée.

Les moyens d'entraînement 62 sont prévus pour provoquer le coulissement du manchon de commande 56 depuis sa position verrouillée vers sa position déverrouillée, à l'encontre de l'élément de rappel 64.

Selon le mode de réalisation représenté ici, les moyens de préhension 26 comportent plusieurs éléments de rappel 64 constitués par des ressorts à boudins de compression.

Les ressorts 64 sont répartis angulairement de manière régulière et ils sont interposés axialement entre une surface radiale annulaire 66 du manchon de support 50, qui est orientée vers le bas, et une surface radiale annulaire 68 en vis-à-vis constituée par la face supérieure d'une collerette radiale externe 70 appartenant au manchon de commande 56.

La collerette radiale externe 70 est agencée ici à l'extrémité axiale supérieure du manchon de commande 56.

Chaque ressort 64 est enroulé autour d'une vis 72 axiale qui traverse la collerette radiale externe 70 du manchon de commande 56 et qui est vissée par son extrémité supérieure filetée 74 dans la surface radiale annulaire 66 du manchon de support 50.

Chaque vis 72 comporte, à son extrémité inférieure, une tête 76 qui est logée axialement dans une encoche 78 associée formée dans la portée radiale 80 constituée par la surface radiale inférieure de la collerette radiale externe 70 du manchon de commande 56.

On note que la profondeur axiale de l'encoche 78 est supérieure à la hauteur axiale de la tête 76.

Chaque encoche 78 est ouverte radialement vers l'extérieur, comme on peut le voir notamment sur la figure 5.

De plus, la collerette radiale externe 70 du manchon de commande 56 comporte, dans chaque encoche 78, une fente 82 qui est ouverte radialement vers l'extérieur et qui permet le passage de la vis 72 associée à travers la collerette radiale externe 70.

Avantageusement, le manchon de support 50 comporte, à son extrémité axiale supérieure, une collerette radiale externe 84 qui s'étend radialement au-delà du diamètre externe du manchon de commande 56.

La collerette radiale externe 84 du manchon de support 50 comporte une surface radiale annulaire inférieure 86 qui est prévue pour venir en appui axial contre une surface transversale supérieure 88 du capot inférieur 44, de manière que la collerette radiale externe 84 puisse être serrée axialement entre le capot supérieur 42 et le capot inférieur 44 du couvercle 32, en vue de retenir axialement le manchon de support 50 sur le couvercle 32.

La surface radiale annulaire inférieure 86 comporte ici un logement pour un joint torique 90 visant à assurer l'étanchéité du contact entre la collerette radiale externe 84 et la surface transversale supérieure 88 associée du capot inférieur 44.

Avantageusement, les moyens d'entraînement 62 du manchon de commande 56 comportent un vérin pneumatique ou hydraulique qui est muni d'un piston 92 lié en coulissement axial au manchon de commande 56, au moins dans le sens du déverrouillage.

Le piston 92 est constitué ici par un manchon tubulaire qui est coaxial et externe au manchon de commande 56.

Le piston 92 comporte, dans sa paroi axiale concave, une surface radiale interne 94 qui est orientée vers le haut et qui est prévue pour venir en appui axial contre une portée radiale 80 associée du manchon de commande 56 pour permettre l'entraînement du manchon de commande 56 par le piston 92 lorsque le piston 92 se déplace axialement vers le haut.

La portée radiale 80 est ici constituée par la surface radiale inférieure de la collerette radiale externe 70 du manchon de commande 56.

Le piston 92 comporte, dans sa paroi axiale convexe, un épaulement radial externe 96 qui est orienté vers le bas et qui délimite axialement, avec une portée radiale 98 en vis-à-vis aménagée dans le corps principal 46 de la tuyère 22, une chambre de commande 100 du piston 92.

Le corps principal 46 de la tuyère 22 comporte ici un conduit 102 d'alimentation en air comprimé qui est raccordé à une source de pression (non représentée). Ainsi, l'augmentation de la pression à l'intérieur de la chambre de commande 100 provoque le coulissement du piston 92 vers le haut, ce qui entraîne le coulissement du manchon de commande 56 vers sa position déverrouillée.

On note que la course axiale du piston 92, et donc du manchon de commande 56, peut être très courte, par exemple de l'ordre de 2,5 mm.

Avantageusement, le manchon de support 50, les billes 54, le manchon de commande 56, les ressorts 64, les vis 72, et le joint torique 90 sont préalablement assemblés de manière à constituer un sous-ensemble 101 interchangeable, qui peut ainsi être monté en une seule opération dans le capot inférieur 44 du couvercle 32.

A cet effet, le capot inférieur 44 du couvercle 32 comporte un logement 103 cylindrique qui débouche coaxialement à l'intérieur du corps principal 46 de la tuyère 22.

Le sous-ensemble 101 est inséré axialement du haut vers le bas dans le logement 103 du capot inférieur 44, jusqu'à ce que la collerette radiale externe 84 du manchon de support 50 vienne en appui axial contre la surface transversale supérieure 88 du capot inférieur 44.

Le sous-ensemble 101 est monté serré axialement entre une surface d'appui appartenant au capot supérieur 42 et la surface transversale supérieure 88 du capot inférieur 44.

On décrit maintenant les moyens de raccordement 28 qui équipent la tuyère 22 selon l'invention.

Les moyens de raccordement 28 sont constitués par un sous-ensemble amovible appelé cartouche 104 qui a une forme globalement tubulaire coaxiale au col du récipient 12.

Conformément aux enseignements de l'invention, la cartouche 104 comporte un tronçon axial, dit tronçon de raccordement 106, qui s'étend à l'intérieur de la chambre 31 de pompage et qui est pourvu d'orifices 108 radiaux.

Selon une autre caractéristique de l'invention, la chambre 31 de pompage communique avec l'intérieur de la cartouche 104 uniquement à travers les orifices 108 radiaux, les dimensions nominales de chaque orifice 108 étant aptes à empêcher la diffusion vers la chambre 31 de pompage des micro-ondes émises à l'intérieur du récipient 12 pendant le traitement.

La cartouche 104 comporte un corps principal 105 tubulaire dont le tronçon d'extrémité axiale inférieure constitue ici le tronçon de raccordement 106.

Selon le mode de réalisation représenté ici, le tronçon de raccordement 106 comporte deux fenêtres 110 diamétralement opposées qui sont découpées dans sa paroi axiale.

Chaque fenêtre 110 est délimitée, circonférentiellement, par deux montants axiaux 112, 114 et, axialement, par deux rebords radiaux 116, 118.

Chaque fenêtre 110 est obturée par un élément de paroi axiale rapporté 120 dans lequel sont agencés les orifices 108 radiaux.

Avantageusement, l'élément de paroi axiale rapporté 120 est constitué par un manchon perforé qui est coaxial au tronçon de raccordement 106, qui est réalisé d'une seule pièce, et qui est inséré axialement à l'intérieur de la cartouche 104 de manière à obturer les deux fenêtres 110.

Le manchon perforé 120 comporte une multitude d'orifices 108 radiaux identiques qui s'étendent sur toute sa surface axiale.

Le manchon perforé 120 est réalisé par exemple en métal.

On note que la dimension nominale de la section de passage de chaque orifice 108 radial et l'épaisseur radiale du manchon perforé 120 sont choisies de manière à empêcher la diffusion vers la chambre 31 de pompage des micro-ondes émises à l'intérieur du récipient 12 pendant le traitement, tout en minimisant les pertes de charge lors du pompage à vide.

La cartouche 104 comporte une entretoise 122 tubulaire qui est emmanchée à force axialement dans l'extrémité axiale inférieure 124 du tronçon de raccordement 106.

L'entretoise 122 est intercalée axialement entre le buvant 16 du récipient 12 et le corps principal 105 de la cartouche 104.

L'extrémité axiale inférieure 126 de l'entretoise 122 est pourvue d'un joint annulaire 128 d'étanchéité qui est prévu pour réaliser un raccordement étanche entre la cartouche 104 et l'intérieur du récipient 12.

Avantageusement, lorsque la cartouche 104 est montée dans le couvercle 32, le joint annulaire 128 vient en appui axial étanche à la fois contre l'épaulement 59 interne du manchon de support 50 et contre le buvant 16 du récipient 12.

L'entretoise 122 est réalisée par exemple en matériau thermoplastique.

Selon le mode de réalisation représenté ici, le corps principal 105 de la cartouche 104 comporte un tronçon d'extrémité axiale supérieure, dit tronçon de liaison 130, qui prolonge le tronçon de raccordement 106 vers le haut.

Le tronçon de liaison 130 possède une paroi axiale pleine et il est en contact étanche, par son extrémité axiale libre supérieure, avec le corps d'un injecteur 132 prévu pour injecter du fluide réactionnel à l'intérieur du récipient 12 pendant le traitement. De façon connue, le fluide réactionnel est par exemple à base d'acétylène, lorsque le revêtement barrière doit être un matériau carboné.

La cartouche 104 comporte une chemise 134 cylindrique qui est agencée contre la paroi axiale concave du tronçon de liaison 130 et qui s'étend globalement sur toute la longueur axiale du tronçon de liaison 130.

Selon le mode de réalisation représenté ici, la chemise 134 cylindrique est montée en butée axiale contre une surface radiale associée 136 qui est orientée vers le bas et qui est agencée au voisinage de l'extrémité axiale supérieure du tronçon de liaison 130.

Le manchon perforé 120 est retenu axialement à l'intérieur de la cartouche 104, en haut par l'extrémité axiale inférieure de la chemise 134 cylindrique, et en bas par l'extrémité axiale supérieure de l'entretoise 122.

Le tronçon de liaison 130 est pourvu d'une collerette radiale externe 138 qui vient en appui axial étanche contre la surface transversale supérieure 140 du couvercle 32, lorsque la cartouche 104 est montée dans le couvercle 32.

La cartouche 104 est prévue ici pour être insérée axialement, du haut vers le bas, dans un logement 142 cylindrique complémentaire du couvercle 32.

Le logement 142 cylindrique est constitué par un trou qui est aménagé dans le capot supérieur 42, axialement en vis-à-vis du logement 103 prévu pour recevoir le manchon de support 50 des moyens de préhension 26.

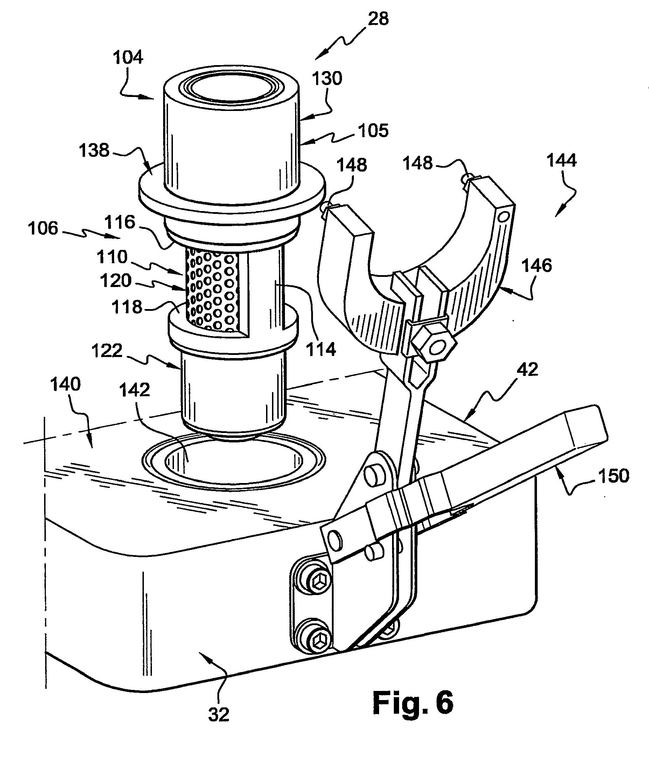

Le couvercle 32 est équipé d'un organe de verrouillage 144 qui comporte une fourche 146 montée pivotante autour d'un axe transversal A3 entre une position angulaire verrouillée, qui est représentée sur la figure 2, et une position angulaire de libération, qui est représentée sur les figures 1 et 6.

La fourche 146 a globalement une forme en U qui s'étend dans un plan transversal en position verrouillée et qui délimite une encoche globalement complémentaire de la forme extérieure du tronçon de liaison 130 de la cartouche 104.

La face transversale inférieure de la fourche 146, en position verrouillée, est munie de moyens 148 d'appui radiaux, constitués ici par deux plots qui s'étendent verticalement vers le bas et qui forment à leurs extrémités axiales inférieures respectivement deux surfaces transversales d'appui prévues pour venir en appui axial contre la face radiale supérieure de la collerette radiale externe 138 du tronçon de liaison 130. Les moyens 148 d'appui radiaux, constitués par les deux plots, sont donc mobiles entre une position verrouillée et une position de libération de la cartouche, selon la position de la fourche 146.

Les plots 148 sont agencés ici au voisinage des extrémités libres de la fourche 146.

De préférence, chaque plot 148 est constitué par une vis qui est vissée dans la face transversale inférieure de la fourche 146 et qui comporte une tête formant surface d'appui.

Ainsi, il est possible de régler précisément la hauteur des surfaces d'appui de la fourche 146 sur la collerette radiale externe 138 en vissant plus ou moins chaque vis constituant un moyen 148 d'appui.

L'organe de verrouillage 144 est équipé d'un levier de commande 150 qui commande le pivotement de la fourche 146 entre ses deux positions angulaires.

Le fonctionnement des moyens de préhension 26 et des moyens de raccordement 28 équipant la machine 10 de traitement selon l'invention est le suivant.

Comme expliqué précédemment, le sous-ensemble 101 est constitué en assemblant le manchon de commande 56 sur le manchon de support 50, avec les billes 54, les ressorts 64 et les vis 72.

De manière similaire, les éléments constituant la cartouche 104, c'est-à-dire son corps principal 105, la chemise 134, le manchon perforé 120, l'entretoise 122, ainsi que les joints d'étanchéité qui l'équipent, sont assemblés au préalable.

Le capot inférieur 44 du couvercle 32 est ouvert, en le faisant pivoter vers le bas autour de son axe A2, de manière à permettre l'insertion axiale du sous-ensemble 101 du haut vers le bas dans le logement 103 associé, comme on l'a représenté sur les figures 1 et 5.

Cette opération est effectuée alors que le couvercle 32 occupe sa position haute de transfert.

Le capot inférieur 44 peut alors être refermé en le faisant pivoter vers le haut contre le capot supérieur 42, de sorte que le sous-ensemble 101 est alors serré axialement entre le capot inférieur 44 et le capot supérieur 42, comme on l'a représenté sur les figures 2, 3, et 4.

L'organe de verrouillage 144 occupant sa position de libération, la cartouche 104 est insérée axialement, du haut ver le bas, dans le logement 142 associé, jusqu'à ce que la collerette radiale externe 138 du tronçon de liaison 130 vienne en appui axial contre la surface transversale supérieure 140 du capot supérieur 42.

Une action sur le levier de commande 150 provoque ensuite le pivotement de la fourche 146 vers sa position verrouillée, telle que représentée sur la figure 2, ce qui bloque axialement la cartouche 104 dans sa position montée.

On note que, dans la position montée de la cartouche 104, le joint annulaire 128, qui équipe l'extrémité axiale inférieure 126 de l'entretoise 122, vient en appui axial étanche contre l'épaulement 59 interne du manchon de support 50 du sous-ensemble 101.

Le corps de l'injecteur 132 peut alors être déplacé axialement vers le bas de manière à venir en appui axial étanche contre l'extrémité axiale supérieure du tronçon de liaison 130 de la cartouche 104, comme on l'a représenté sur la figure 4.

On note que, pour simplifier la représentation, les éléments de l'injecteur 132 n'ont pas été représentés sur les autres figures.

A ce stade, les moyens de préhension 26 et les moyens de raccordement 28 étant montés sur le couvercle 32, ils sont prêts à fonctionner.

La phase de préhension d'un récipient 12 se déroule de la manière suivante.

Le récipient 12 à saisir est placé axialement sous la tuyère 22, par exemple par l'intermédiaire d'une roue d'alimentation (non représentée), comme représenté sur la figure 3.

Le manchon de commande 56 est commandé depuis sa position de préhension jusqu'à sa position de libération, telle que représentée sur la figure 3, par l'intermédiaire du piston 92 pour permettre l'insertion du col 14 du récipient 12 dans le manchon de support 50.

Des moyens de commande (non représentés) provoquent le coulissement axial du couvercle 32 vers le bas, jusqu'à ce le col 14 du récipient 12 soit reçu axialement à l'intérieur du tronçon cylindrique d'extrémité axiale inférieure 53 du manchon de support 50.

En relâchant la pression dans la chambre de commande 100 du piston 92, le manchon de commande 56 est entraîné vers sa position verrouillée sous l'action des ressorts 64, ce qui sollicite radialement les billes 54 vers leur position de préhension, contre la paroi axiale du col 14 du récipient 12, comme on l'a représenté sur la figure 4.

L'appui radial des billes 54 contre la première collerette radiale externe 18 sollicite légèrement le récipient 12 vers le haut, de sorte que le buvant 16 vient bien en appui axial étanche contre le joint annulaire 128 équipant l'entretoise 122.

A ce stade, le récipient 12 est saisie par les moyens de préhension 26, ce qui permet au couvercle 32 de poursuivre son coulissement axial vers le bas, de manière à introduire axialement le récipient 12 à l'intérieur de l'enceinte 34 pour permettre son traitement.

Le couvercle 32 descend jusqu'à sa position axiale de traitement, qui est représentée sur la figure 4, dans laquelle la tuyère 22 vient fermer de manière étanche l'enceinte 34.

Dans la position axiale de traitement, le pompage à vide de l'intérieur du récipient 12 peut commencer, ainsi que le traitement du récipient 12.

Après le traitement du récipient 12, le couvercle 32 est commandé en coulissement vers sa position haute de transfert, et le manchon de commande 56 est commandé dans sa position de libération, pour permettre l'évacuation du récipient 12 traité hors de la machine.

Les moyens de préhension 26 et le couvercle 32 peuvent alors être commandé de manière à saisir un nouveau récipient 32 à traiter, de la même manière que décrite précédemment.

Pendant le traitement du récipient 12, les micro-ondes émises à l'intérieur de l'enceinte 34 provoquent des dépôts de carbone sur les faces axiales internes de la cartouche 104.

Grâce au tronçon de raccordement 106 et au manchon perforé 120, le champ des micro-ondes est cantonné à l'intérieur de la cartouche 104 ce qui empêche le dépôt de carbone dans la chambre 31 de pompage.

Après le traitement d'un nombre déterminé de récipients 12, la cartouche 104 peut être démontée de manière à permettre le nettoyage des surfaces qui ont subi des dépôts de carbone répétés.

Dans la machine 10 selon l'invention, le démontage de la cartouche 104 est facilité puisqu'il suffit de faire coulisser axialement le corps de l'injecteur 132 vers le haut, celui-ci nécessitant aussi un nettoyage, puis de faire pivoter la fourche 146 vers sa position de libération. La cartouche 104 peut alors être retirée manuellement, sans outil, et être replacée tout aussi facilement.

Avantageusement, une cartouche 104 de remplacement peut être prévue de manière à permettre le nettoyage de la cartouche 104 usagée en temps masqué pendant le fonctionnement de la machine 10.

On note que le dépôt de carbone à l'intérieur de la cartouche 104 diminue exponentiellement vers le haut. Par conséquent, le dépôt de carbone se concentre principalement sur la surface axiale concave de l'entretoise 122.

Le nettoyage de la cartouche 104 peut donc se résumer au nettoyage de l'entretoise 122 et de son joint annulaire 128.

Les moyens de préhension 26 selon l'invention présentent l'avantage d'être agencés en dehors du champ des micro-ondes, de sortent qu'ils ne subissent pas de dépôt de carbone.

Comme les moyens d'entraînement 62 du manchon de commande 56 sont montés sur le corps principal 46 de la tuyère 22 qui est lui-même fixé sur le capot inférieur 44 du couvercle 32, le sous-ensemble 101 peut être démonté sans qu'il soit nécessaire de démonter les moyens d'entraînement 62.

Ceci permet de prévoir des sous-ensembles 101 interchangeables en fonction de la forme du col 14 du récipient 12, sans qu'il soit nécessaire de modifier les moyens d'entraînement 62 et/ou le corps principal 46 de la tuyère 22.

De plus, l'opération de changement du sous-ensemble 101 est particulièrement simple puisqu'il suffit de faire basculer le capot inférieur 44 du couvercle 32 vers le bas.

Les moyens de préhension 26 selon l'invention facilitent la personnalisation du poste de traitement 11 en fonction de la forme des récipients 12 à traiter.

On note que la tuyère 22 est pourvue de plusieurs joints d'étanchéité, qui n'ont pas tous été référencés, pour assurer le pompage à vide dans le récipient 12 et la fermeture étanche de l'enceinte de traitement 34.

De préférence, un capteur de proximité (non représenté) qui est agencé sur le couvercle 32 détecte les moments où il faut commander le manchon de commande 56 en position de préhension ou de libération. Ce capteur de proximité peut être lié électriquement à une électrovanne qui commande la pression dans la chambre de commande 100, ce qui permet de commander les moyens de préhension 26 directement par le capteur de proximité, sans qu'il soit nécessaire de passer par l'unité de commande du poste de traitement 11 ou de la machine 10.

Grâce aux moyens de préhension 26 selon l'invention, il n'est pas nécessaire d'appliquer un effort de maintien pour maintenir le manchon de commande 56 en position verrouillée puisque cette position correspond à une position stable de repos grâce à l'action des ressorts 64.

De plus, dans la machine 10 selon l'invention, il n'est pas nécessaire d'exercer un effort sur le récipient 12 pour la libérer ou pour la saisir.

## Revendications

1. Machine (10) de traitement de récipients (12) par dépôt d'un revêtement interne formant barrière au moyen d'un plasma micro-ondes, notamment en vue de permettre le conditionnement de liquides oxydo-sensibles dans les récipients (12), comportant au moins un poste de traitement (11) pour un récipient (12) muni d'un col (14), du type dans laquelle chaque poste de traitement (11) comporte une enceinte (34) de traitement qui est prévue pour contenir le récipient (12) et un couvercle (32) qui est monté coulissant axialement par rapport à l'enceinte (34) et qui est pourvu d'une tuyère (22) équipée de moyens de préhension (26) pour saisir extérieurement le récipient (12) par son col (14) de manière à permettre l'insertion axiale du récipient (12) à l'intérieur de l'enceinte (34) par une ouverture correspondante (38), et équipée de moyens de raccordement (28) étanche entre l'intérieur du récipient (12) et une chambre (31) de pompage à vide qui est aménagée dans le couvercle (32), du type dans laquelle les moyens de raccordement (28) étanche comportent une cartouche (104) qui est montée dans le couvercle (32), qui a une forme globalement tubulaire coaxiale au col (14) du récipient (12), et qui est en contact étanche avec le buvant (16) du récipient (12) saisi par les moyens de préhension (26),
**caractérisée en ce que** la cartouche (104) comporte un tronçon axial, dit tronçon de raccordement (106), qui s'étend à l'intérieur de la chambre (31) de pompage et qui est pourvu d'orifices (108) radiaux, et **en ce que** la chambre (31) de pompage communique avec l'intérieur de la cartouche (104) à travers les orifices (108) radiaux, les dimensions nominales de chaque orifice (108) étant aptes à empêcher la diffusion vers la chambre (31) de pompage des micro-ondes émises à l'intérieur du récipient (12) pendant le traitement.

2. Machine (10) selon la revendication précédente, **caractérisée en ce que** la paroi axiale du tronçon de raccordement (106) comporte au moins une fenêtre (110) et **en ce que** chaque fenêtre (110) est obturée par un élément de paroi axiale (120) rapporté dans lequel sont agencés les orifices (108).

3. Machine (10) selon la revendication précédente, **caractérisée en ce que** l'élément de paroi axiale (120) est constitué par un manchon perforé rapporté à l'intérieur de la cartouche (104).

4. Machine (10) selon l'une quelconque des revendications précédentes, **caractérisée en ce que** la cartouche (104) comporte un tronçon axial formant une entretoise (122) tubulaire qui est intercalée axialement entre le buvant (16) du récipient (12) et le tronçon de raccordement (106), et qui est fixée sur une extrémité axiale associée du tronçon de raccordement (106).

5. Machine (10) selon la revendication précédente, **caractérisée en ce que** la cartouche (104) comporte un joint annulaire (128) d'étanchéité qui réalise le raccordement étanche entre la cartouche (104) et le buvant (16) du récipient (12) et qui est fixé sur l'extrémité axiale (126) de l'entretoise (122) opposée au tronçon de raccordement (106).

6. Machine (10) selon la revendication précédente, **caractérisée en ce que** les moyens de préhension (26) comportent un manchon de support (50), tubulaire et coaxial au col (14) du récipient (12), qui est monté dans un logement (103) du couvercle (32), et **en ce que** la paroi axiale concave du manchon de support (50) comporte un épaulement (59) qui est prévu pour venir en appui axial contre le joint annulaire (128) d'étanchéité de la cartouche (104).

7. Machine (10) selon l'une quelconque des revendications précédentes, **caractérisée en ce que** la cartouche (104) comporte, du côté opposé au récipient (12), un tronçon d'extrémité axiale dit tronçon de liaison (130) qui possède une paroi axiale pleine et qui est en contact étanche, par son extrémité axiale libre, avec le corps d'un injecteur (132) prévu pour injecter un fluide réactionnel à l'intérieur du récipient (12) pendant le traitement.

8. Machine (10) selon la revendication précédente, **caractérisée en ce que** le tronçon de liaison (130) a globalement une forme cylindrique et **en ce que** la cartouche (104) comporte une chemise (134) cylindrique qui est agencée contre la paroi axiale concave du tronçon de liaison (130) et qui s'étend globalement sur toute la longueur axiale du tronçon de liaison (130).

9. Machine (10) selon la revendication précédente, **caractérisée en ce que** le tronçon de liaison (130) et le tronçon de raccordement (106) sont réalisés d'une seule pièce et ils constituent le corps principal (105) de la cartouche (104).

10. Machine (10) selon l'une quelconque des revendications précédentes, **caractérisée en ce que** la cartouche (104) est montée dans un logement (142) complémentaire du couvercle (32), **en ce que** le couvercle (32) comporte un organe de verrouillage (144) qui est muni de moyens (148) d'appui radiaux mobiles entre une position verrouillée et une position de libération, et **en ce que** la cartouche (104) comporte une collerette radiale externe (138) qui est prévue pour être serrée axialement entre une portion associée du couvercle (32) et les moyens (148) d'appui de l'organe de verrouillage (144) en position verrouillée de manière à retenir la cartouche (104) en position montée dans le logement (142) du couvercle (32).

## Claims

1. A machine (10) for the treatment of containers (12) by the depositing of a barrier-forming internal coating by means of a microwave plasma, especially for the purpose of allowing the packaging of oxidation-sensitive liquids in the containers (12), said machine comprising at least one treatment station (11) for a container (12) equipped with a neck (14), of the type in which each treatment station (11) comprises a treatment enclosure (34) which is intended for containing the container (12), and a cover (32) which is mounted axially slidably with respect to the enclosure (34) and which is provided with a nipple (22) equipped with gripping means (26) for grasping the container (12) externally by its neck (14), so as to allow the axial insertion of the container (12) into the enclosure (34) via a corresponding aperture (38), and equipped with leaktight connection means (28) between the interior of the container (12) and a vacuum-pumping chamber (31) which is arranged in the cover (32), of the type in which the leaktight connection means (28) comprise a cartridge (104) which is mounted in the cover (32), which has a substantially tubular shape coaxial with respect to the neck (14) of the container (12) and which is in leaktight contact with the lip (16) of the container (12) grasped by the gripping means (26),
**characterized in that** the cartridge (104) comprises an axial portion, called a connection portion (106), which extends inside the pumping chamber (31) and which is provided with radial ports (108), and **in that** the pumping chamber (31) communicates with the interior of the cartridge (104) via the radial ports (108), the nominal dimensions of each port (108) being capable of preventing the diffusion towards the pumping chamber (31) of microwaves emitted inside the container (12) during treatment.

2. The machine (10) as claimed in the preceding claim, **characterized in that** the axial wall of the connection portion (106) comprises at least one window (110), and **in that** each window (110) is shut off by means of an attached axial wall element (120) in which the ports (108) are arranged.

3. The machine (10) as claimed in the preceding claim, **characterized in that** the axial wall element (120) consists of a perforated cuff attached inside the cartridge (104).

4. The machine (10) as claimed in any one of the preceding claims, **characterized in that** the cartridge (104) comprises an axial portion forming a tubular spacer (122) which is inserted axially between the lip (16) of the container (12) and the connection portion (106) and which is fastened to an associated axial end of the connection portion (106).

5. The machine (10) as claimed in the preceding claim, **characterized in that** the cartridge (104) comprises an annular sealing ring (128) which makes the leaktight connection between the cartridge (104) and the lip (16) of the container (12) and which is fastened to the opposite axial end (126) of the spacer (122) to the connection portion (106).

6. The machine (10) as claimed in the preceding claim, **characterized in that** the gripping means (26) comprise a tubular supporting cuff (50) which is coaxial with respect to the neck (14) of the container (12) and which is mounted in a receptacle (103) of the cover (32), and **in that** the concave axial wall of the supporting cuff (50) comprises a shoulder (59) which is intended to come to bear axially against the annular sealing ring (128) of the cartridge (104).

7. The machine (10) as claimed in any one of the preceding claims, **characterized in that** the cartridge (104) comprises, on the opposite side to the container (12), an axial end portion, called a junction portion (130), which possesses a solid axial wall and which is in leaktight contact at its free axial end with the body of an injector (132) intended for injecting a reaction fluid into the container (12) during treatment.

8. The machine (10) as claimed in the preceding claim, **characterized in that** the junction portion (130) has a substantially cylindrical shape, and **in that** the cartridge (104) comprises a cylindrical sleeve (134) which is arranged against the concave axial wall of the junction portion (130) and which extends substantially over the entire axial length of the junction portion (130).

9. The machine (10) as claimed in the preceding claim, **characterized in that** the junction portion (130) and the connection portion (106) are produced in one piece, and they form the main body (105) of the cartridge (104).

10. The machine (10) as claimed in any one of the preceding claims, **characterized in that** the cartridge (104) is mounted in a complementary receptacle (142) of the cover (32), **in that** the cover (32) comprises a locking member (144) which is provided with radial bearing means (148) movable between a locked position and a release position, and **in that** the cartridge (104) comprises an outer radial collar (138) which is intended to be clamped axially between an associated portion of the cover (32) and the bearing means (148) of the locking member (144) in the locked position, so as to retain the cartridge (104) in the mounted position in the receptacle (142) of the cover (32).

## Patentansprüche

1. Maschine (10) zum Bearbeiten von Aufnahmebehältern (12) durch Ablagern einer inneren Beschichtung, die eine Sperre bildet, mittels eines Mikrowellenplasmas, um insbesondere das Verpacken von sauerstoffempfindlichen Flüssigkeiten in den Behältern (12) zu ermöglichen, mit wenigstens einer Bearbeitungsstation (11) für einen mit einem Hals (14) versehenen Behälter (12) des Typs, bei dem jede Bearbeitungsstation (11) ein Bearbeitungsgehäuse (34) aufweist, das vorgesehen ist, um den Aufnahmebehälter (12) zu enthalten, und einen Deckel aufweist, der axial gleitend in Bezug auf das Gehäuse (34) montiert ist und der mit einem Schlauch (22) versehen ist, der mit einem Greifmittel (26) ausgerüstet ist, um den Behälter (12) an seinem Hals (14) von außen zu ergreifen, um so das axiale Einsetzen des Behälters (12) in den Innenraum des Gehäuses (34) durch eine entsprechende Öffnung (38) zu ermöglichen, und mit Mitteln (28) zum dichten Verbinden zwischen dem Innenraum des Behälters (12) und einer Vakuumpumpkammer (31), die in dem Deckel (32) ausgebildet ist, ausgerüstet ist, wobei die dichten Verbindungsmittel (28) von einem Typ sind, der eine Patrone (104) enthält, die in dem Deckel (32) montiert ist und eine zu dem Hals (14) des Behälters (12) koaxiale im Allgemeinen röhrenförmige Form hat und in dichtem Kontakt mit dem Trinkauslass (16) des Behälters (12), der von den Greifmitteln (26) ergriffen wird, ist,
**dadurch gekennzeichnet, dass** die Patrone (104) ein axiales Teilstück, das Verbindungsteilstück (106) genannt wird, umfasst, das sich innerhalb der Pumpkammer (31) erstreckt und mit radialen Öffnungen (108) versehen ist, und dass die Pumpkammer (31) mit dem Innenraum der Patrone (104) durch die radialen Öffnungen (108) kommuniziert, wobei die Nennabmessungen jeder Öffnung (108) geeignet sind, um die Diffusion in die Pumpkammer (31) von Mikrowellen, die von innerhalb des Behälters (12) während der Bearbeitung ausgesendet werden, zu verhindern.

2. Maschine (10) nach dem vorhergehenden Anspruch, **dadurch gekennzeichnet, dass** die axiale Wand des Verbindungsteilstücks (106) wenigstens ein Fenster (110) aufweist und dass jedes Fenster (110) durch ein angefügtes axiales Wandelement (120), in dem die Öffnungen (108) angeordnet sind, verschlossen ist.

3. Maschine (10) nach dem vorhergehenden Anspruch, **dadurch gekennzeichnet, dass** das axiale Wandelement (120) durch eine perforierte Muffe gebildet ist, die innerhalb der Patrone (104) angefügt ist.

4. Maschine (10) nach einem der vorhergehenden Ansprüche, **dadurch gekennzeichnet, dass** die Patrone (104) ein axiales Teilstück aufweist, das einen rohrförmigen Abstandshalter (122) bildet, der axial zwischen den Trinkauslass (16) des Behälters (12) und das Verbindungsteilstück (106) eingefügt ist und das an einem dem Verbindungsteilstück (106) zugeordneten axialen Ende befestigt ist.

5. Maschine (10) nach dem vorhergehenden Anspruch, **dadurch gekennzeichnet, dass** die Patrone (104) eine Ringdichtung (128) aufweist, die die dichte Verbindung zwischen der Patrone (104) und dem Trinkauslass (116) des Behälters (12) schafft und die an dem axialen Ende (126) des Abstandshalters (122) gegenüber dem Verbindungsteilstück (106) befestigt ist.

6. Maschine (10) nach dem vorhergehenden Anspruch, **dadurch gekennzeichnet, dass** die Greifmittel (26) eine Tragmuffe (50) umfassen, die rohrförmig und zu dem Hals (14) des Behälters (12) koaxial ist und in einem Aufnahmesitz (103) des Deckels (32) montiert ist, und dass die konkave axiale Wand der Tragmuffe (50) eine Schulter (59) aufweist, die vorgesehen ist, um sich an der ringförmigen Dichtung (128) der Patrone (104) axial abzustützen.

7. Maschine (10) nach einem der vorhergehenden Ansprüche, **dadurch gekennzeichnet, dass** die Patrone (104) auf der dem Behälter (12) gegenüberliegenden Seite ein axiales Endteilstück aufweist, das Anschlussteilstück (130) genannt wird und eine axiale Vollwand besitzt und mit seinem freien axialen Ende mit dem Körper einer Einspritzeinrichtung (132), die dazu vorgesehen ist, ein Reaktionsfluid in den Behälter (12) während der Bearbeitung einzuspritzen, in dichtem Kontakt ist.

8. Maschine (10) nach dem vorhergehenden Anspruch, **dadurch gekennzeichnet, dass** das Anschlussteilstück (130) eine im Allgemeinen zylindrische Form hat und dass die Patrone (104) eine zylindrische Schürze (134) aufweist, die an der konkaven axialen Wand des Anschlussteilstücks (130) angeordnet ist und sich im Allgemeinen über die gesamte axiale Länge des Anschlussteilstücks (130) erstreckt.

9. Maschine (10) nach dem vorhergehenden Anspruch, **dadurch gekennzeichnet, dass** das Anschlussteilstück (130) und das Verbindungsteilstück (106) einteilig ausgebildet sind und den Hauptkörper (105) der Patrone (104) bilden.

10. Maschine (10) nach einem der vorhergehenden Ansprüche, **dadurch gekennzeichnet, dass** die Patrone (104) in einem komplementären Aufnahmesitz (142) des Deckels (32) montiert ist, dass der Deckel (32) ein Verriegelungsorgan (144) aufweist, das mit radialen Abstützmitteln (148) versehen ist, die zwischen einer verriegelten Position und einer freien Position beweglich sind, und dass die Patrone (104) einen äußeren radialen Kranz (138) aufweist, der vorgesehen ist, um axial zwischen einen dem Deckel (32) zugeordneten Abschnitt und die Abstützmittel (148) des Verriegelungsorgans (144) in der verriegelten Position geklemmt zu werden, um die Patrone (104) in der im Aufnahmesitz (142) des Deckels (32) montierten Position zu halten.
